# EUROPEAN PATENT APPLICATION

(11) **EP 0 732 745 A2**
(43) Date of publication of application: **18.09.1996**
(21) Application number: 96301784.3
(22) Date of filing: 15.03.1996
(51) Int. Cl.: H01L 23/66

(54) **Microstrip microwave package**

(30) Priority: 16.03.1995 GB 9505269
(71) Applicant: OXLEY DEVELOPMENTS CO., LTD., Ulverston Cumbria LA12 9QG (GB)
(72) Inventor: North, Stephen John, Barrow-in-Furness, Cumbria, LA13 0PY (GB); Topham, Peter, Northampton (GB); Marsh, Stephen, Northampton (GB)
(74) Representative: W.P. Thompson & Co.

(57) **Abstract**

A package for devices which operate at microwave frequencies, comprising a base (1) of metal or metallised non-conductor to act as a support member of the package and also as a thermal and electrical ground for a device when mounted within the package, an electrically insulating layer (2) on the base (1), an electrically non-conductive lid (4) having a peripheral region which is sealingly coupled to the electrically insulating layer (2) whereby the lid (4) defines, at least in part, an internal cavity (6) of the package which in use receives said device, and at least one metallic track (5) which runs from an internal connection zone (14) within the internal cavity (6), where it can be connected to said device, to an external connection zone (15) of the package where it can be connected to external circuitry. The track (5) is configured such as to maintain, at operating frequencies, a substantially constant impedance along its length when the lid (4) is in place.

## Description

The present invention relates to packages for devices such as integrated circuits (ICs) and similar devices and especially to such devices operating at high frequencies up to and beyond 10GHz.

The most common solutions to packaging integrated circuits have used a metal lead frame for the interconnections with the IC die protected by moulded plastic; the lead frame can form dual-in-line (DIL) pins for PCB insertion or, more recently, be formed for surface mounting (SM). As discussed hereafter, the standard DIL and SM packages are unsuitable for high frequency operation and so alternative solutions for microwave frequencies have been proposed, either with leads for microstrip circuits [US-A-4626805 (Reference 1)] or co-planar circuits [US-A-5294897 (Reference 2)]; or for directly bonding into microstrip circuits ["Microwave and millimetre-wave packaging and interconnection methods for single and multiple chip modules" D. Wein et al, GaAs IC Symposium Technical Digest pp 333-336, 1993 (Reference 3)] , [US-A-4924076 (Reference 4)].

The existing solutions used for IC packaging suffer from a number of disadvantages. The conventional leaded (DIL or SM) packages (references 1, 2 and 4) and also the packages known from "High performance 20 GHz packages for GaAs MMICs" MSN & Communications Technology, Microwave Systems News, January 1988" (Reference 5) have high lead inductance and so are limited to frequencies below 1 GHz. The surface mount packages also stand proud of the interconnecting circuitry and this is a disadvantage where low profile packages are needed.

The package of reference 1, although having leads on the outside of the package uses microstrip lines within the package to give good high frequency performance. The disadvantages with this package are that it is fabricated from several components and so is complex to manufacture and the use of a ceramic carrier for the packaged device results in a relatively high thermal resistance which can cause excessive temperature rise for high dissipation devices.

The package of reference 2 also overcomes the inductance of the leads but by use of a co-planar rather than a microstrip arrangement. This is somewhat simpler in construction than the package of reference 1 but still suffers from a relatively high thermal resistance from the active device to the base of the package.

The package of reference 3 has a metal lid with grounding vias around the package perimeter which encloses the circuit inside a metal cavity. Cavity resonances limit the size of this cavity for operation at high frequencies and makes scaling of packages for higher pin counts difficult.

The problem of thermal resistance is overcome in the package of reference 3 by fabricating the base of the package in metal or in reference 4 by providing an array of metal filled vias. However, these packages still have a relatively complex construction which requires many through vias to be formed through the thickness of the package.

The package of reference 5 uses laser profiled ceramic substrates which are subsequently metallised with thin or thick film metallisation. These substrates are bonded together using glass seal materials. The disadvantage of this manufacturing technique is the complexity of the assembly and thus the cost.

The use of tungsten co-fired metallisation within the ceramic body of existing packages increases the resistivity and losses in the microstrip conductor and thus lowers the performance of the package.

The attachment of a lid to the package requires the use of either polymer or metal alloy materials to bond the lid to the package. Lid attach techniques used for the existing microwave IC package types require relatively complex and expensive jigs for the assembly of components.

In accordance with the present invention, there is provided a package for devices which operate at microwave frequencies, comprising a base of metal or metallised non-conductor to act as a support member of the package and also as a thermal and electrical ground for a device when mounted within the package, an electrically insulating layer on the base, an electrically non-conductive lid having a peripheral region which is sealingly coupled to the electrically insulating layer whereby the lid defines, at least in part, an internal cavity of the package which in use receives said device, and at least one metallic track which runs from an internal connection zone within the internal cavity, where it can be connected to said device, to an external connection zone of the package where it can be connected to external circuitry, said track being configured such as to maintain, at operating frequencies, a substantially constant impedance along its length when the lid is in place.

By "substantially constant impedance", we mean that the impedance is sufficiently constant to avoid reflections between input and output signals and a frequency response free from resonances.

In a preferred embodiment, there is a cut-out in said electrically insulating layer through to said base to provide part of said internal cavity for receiving and accommodating said device.

In other embodiments, said insulating layer is continuous and does not contain said cut-out through to the base. In this case, a metallised area can be provided on the insulating layer for receiving the IC device, the metallised area being grounded to the base by way of conductive vias formed through said insulating layer.

Preferably, the track or at least some of the tracks are of a width to give a specified, constant characteristic impedance. One way in which this can be achieved is for the track or track tracks to be "necked", ie to be of reduced width, where it or they pass under said region of the lid, usually formed by side walls of the lid, whereby to maintain said constant impedance when the lid is in place.

In some embodiments, the lid can be in contact with the track or tracks where it or they pass under said peripheral region of the lid.

In some embodiments the base is a metal. In other embodiments the base can be a metallised insulating member.

The insulating layer and the lid are preferably made of a ceramic material. Alternatively, they can be made of another insulating material, such as plastics.

Advantageously, the insulating layer carries or includes integral lid markers for self-aligning the lid automatically into its correct position when it is applied to said insulating layer.

Preferably, in the case of a rectangular package, there is a respective one of said lid markers at each of the four corners of the package.

The invention provides a package for semi-conductor devices, such as ICs, which can be produced at low cost, has low electrical loss at microwave operating frequencies and also provides a low thermal resistance between the packaged device and the base of the package. The invention may provide a package for a passive device such as a coupler.

Packages in accordance with the invention advantageously utilise co-fired ceramic and thick-film techniques which provide high density ceramic microstrip structures. Commonly, the manufacture of high frequency packages has been limited in operation due to limitations in the electrical response of the materials used, dimensional controls and surface roughness of the ceramic used. Processes have been developed that enable high density ceramics structures to be manufactured with accurate control of the ceramic grain structure and thus the surface finish. It has been demonstrated that thick-film tungsten co-fired ceramic that is subsequently nickel and gold plated has low electrical loss at microwave and millimetre-wave frequencies.

This present invention provides in a preferred embodiment an IC package fabricated on a ceramic substrate mounted on a metal base, with interconnections which have been designed to operate at microwave frequencies. The manufacture utilises both co-fired ceramic and polymer bonding techniques to produce a low cost package.

Embodiments in accordance with the present invention can overcome the disadvantages in existing microwave packages by the application of the following features:
(i) It can use only a single ceramic layer for its construction and requires no through vias, this results in a simple manufacturing process and so low cost.
(ii) The use of a ceramic lid protects the active devices from accidental damage without the need for the through vias to ground the lid seal area of a metal lid. The use of a ceramic lid overcomes the cavity resonances associated with a metal lid and allows operation at high frequencies and simplifies scaling of the package for higher pin counts.
(iii) The use of one or more constant impedance microstrip tracks results in a wide bandwidth of operation. The impedance is held constant where the microstrip tracks cross under the wall of the lid by necking the tracks.
(iv) The use of a metal base for the package ensures low impedance grounding for the packaged device (which is often important for high frequency circuits) and a low thermal resistance to the ground plane (which is important for high dissipation circuits).
(v) The provision of a cavity for the device allows the surfaces to be on the same level which minimises bond length and hence bond inductance, which is important in high frequency circuits.
(vi) The height of the package can match the height of the external microstrip circuit and so minimise the length of the external connections and simplify connecting to the package.
(vii) Having the package ports planar with the surrounding circuit gives low profile construction.
(viii) The microstrip package track or tracks can be manufactured so that the entire conductor has a gold finish and thus low microwave loss.
(ix) The use of integral lid alignment features on the package enables the lid to self-align to the package.

The combination of these preferred features of the present invention overcomes the limitations of the existing approaches to packaging devices and circuits for high frequency operation. The use of one or more microstrip tracks for interconnections eliminates the lead inductance present in DIL packages. The use of a metal base results in a thermal resistance which is much lower than that of the packages described in references 1 and 2. The package design described further hereinafter, results in a simpler construction, notably without through vias, than the packages of references 3 and 4.

The invention is described further hereinafter, by way of example only, with reference to the accompanying drawings, in which:-
Figs. 1 and 2 are cross-sectional and plan views of one embodiment of a microwave package in accordance with the present invention;
Fig. 3 is a plan view showing the details of package metallisation incorporating necked tracks;
Fig. 4 shows in more detail a typical necked track;
Fig. 5 is an experimental characteristic curve illustrating the effectiveness of necked tracks in maintaining a constant impedance;
Fig. 6 is an experimental characteristic curve showing the insertion loss of a through-connected package incorporating the present invention;
Fig. 7 is an exploded perspective view of the embodiment of Fig. 1; and
Fig. 8 is a cross-sectional view corresponding to Fig. 1 but showing an alternative embodiment having a continuous substrate with localised metallisation.

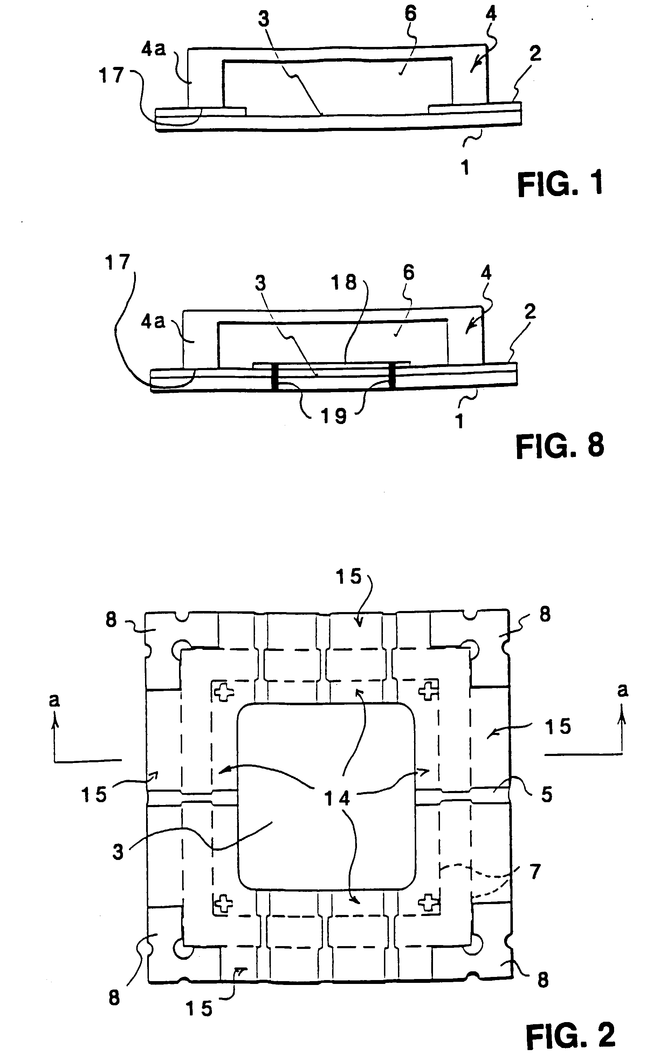

As shown in cross-section of Fig. 1, the package comprises a (usually planar) metal base (1), and a ceramic substrate (2) attached to the metal base, with a cavity (3) defined in the ceramic substrate to accommodate a semi-conductor device (not shown) to be packaged. A ceramic lid (4) is attached to the ceramic substrate once the device (not shown) has been bonded into the package. In this case, the lid (4) has a depending peripheral wall (4a) whose underside surface (17) defines a region of the lid which is coupled to the ceramic substrate. In other embodiments, the lid could be flat and the ceramic substrate could be profiled to achieve the internal cavity (6) when the flat lid is in place.

The operation of the package can be more clearly understood with reference to Fig. 2, which shows a diagrammatic plan view of the package with the lid removed. In the centre of the package is the rectangular cut-out (3) in the ceramic substrate exposing the metal base below. Metal tracks (5) run from an internal connection zone 14 at the edge of the cavity (3) to an external connection zone 15 at the outside edge of the package, where they can be bonded onto external microstrip tracks. The ceramic lid (4) also defines a cavity (6) which is larger than the device cavity (3) so as to leave parts of the tracks (5) exposed within the cavity (6) for bonding at the edge of the device cavity (3). The positions of the walls of the lid (4) are indicated as chain lines 7 in Fig. 2. The tracks (5) are "necked", ie of reduced width, where they pass under the walls and this feature is explained more clearly below.

The manufacture of the package utilises green tape processing methods and preferably includes a lid alignment mechanism as an integral part of the package structure. This mechanism uses a raised ceramic L-shape (8) in each of the package corners which enables the lid (4) to be positioned within the L-sections (8) of the package during the lid attach heating cycle. Previously separate jigs would be required for accurate alignment of the lid to the package.

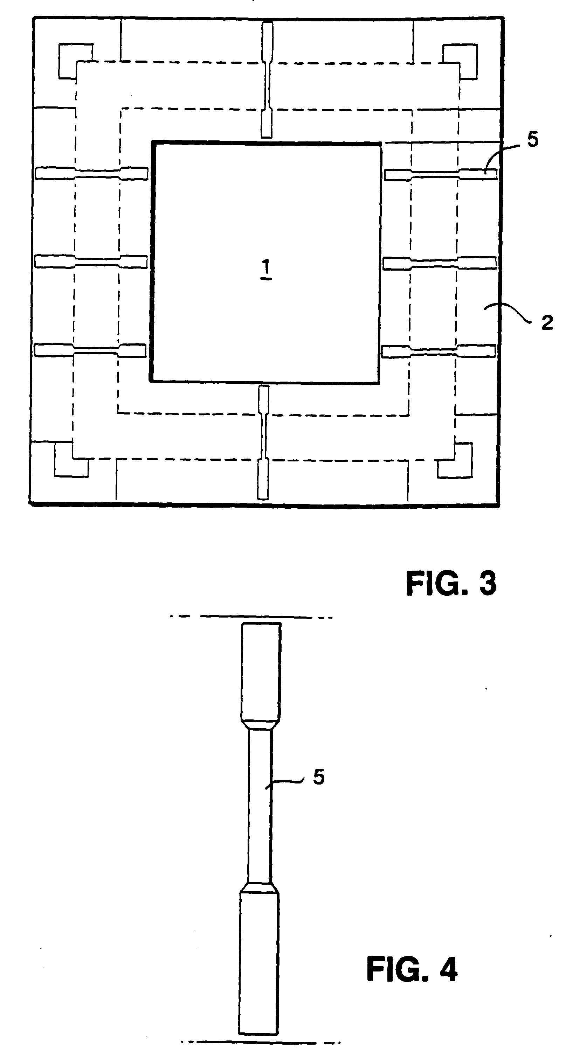

If the metal tracks (5) were to be of uniform width, then the placing of the ceramic lid (4) onto the microstrip line would lower the impedance of the line due to the change in the dielectric constant of the layer above the line (which previously was air). This change in impedance could produce reflections of the input and output signals and so degrade the signals. To overcome this problem in this embodiment, each track is "necked" to reduce its width where it passes under the side wall of the lid. The reduction in width is chosen to maintain a substantially constant impedance when the loading effect of the ceramic is taken into account. An example of a package using necked tracks is shown in Fig. 3 and a detail of the necked track section is shown in Fig. 4.

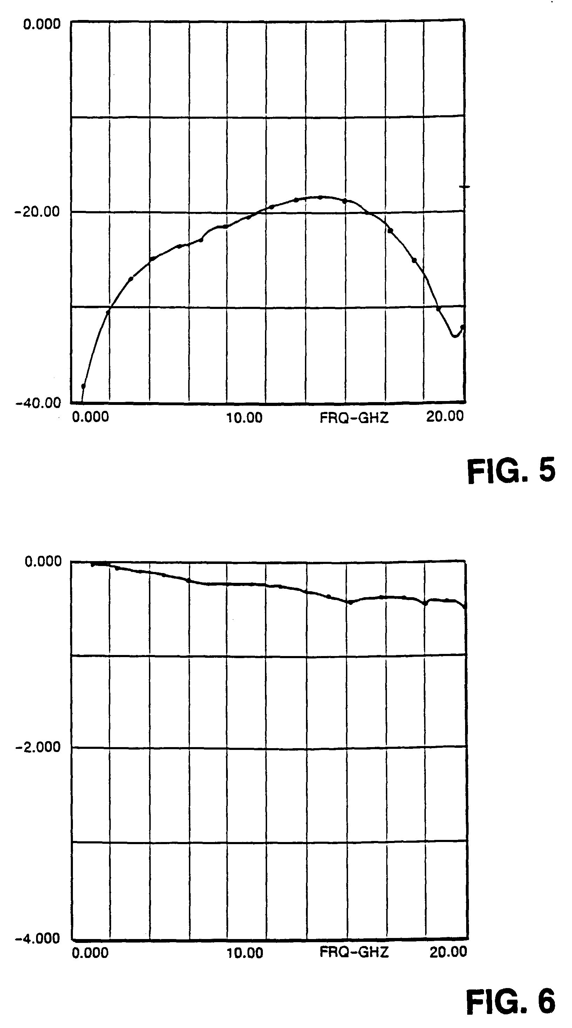

The effectiveness of the necked tracks in maintaining a constant impedance can be gauged from the return loss of better than 18db (Fig. 5) for frequencies up to 20 GHz. The constant track impedance minimises reflections and ensures a frequency response free from resonances. Fig. 6 shows a practical example of the measured insertion loss of a package in which a 50Ω through track takes the place of the active device. The loss of each of the two signal leads is estimated to be less than 0.1dB up to 20GHz, in this example.

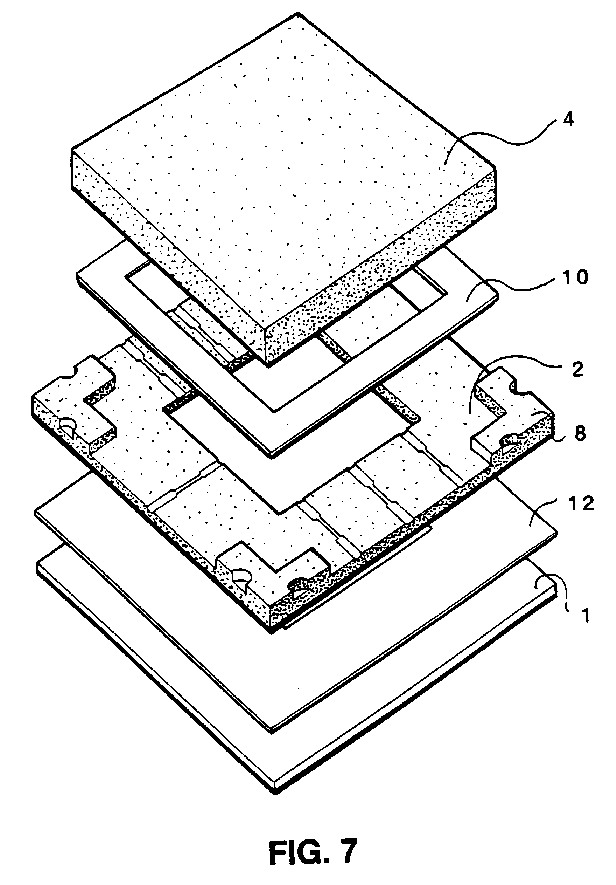

In the exploded perspective view of Fig. 7, reference numeral 4 identifies the ceramic lid, reference numeral 10 identifies a first epoxy bond layer, reference numeral 2 identifies the ceramic substrate with 50Ω feedthrough tracks, reference numeral 8 identifies the corner devices for lid and lead frame alignment, reference numeral 12 identifies a second epoxy bond layer and reference numeral 1 identifies the W/Cu heatsink.

The modified embodiment of Fig. 8 has a continuous electrically insulating layer (2) carrying a metallised area (18) for receiving the semi-conductor device. The metallised area (18) is grounded to the metal base (1) by way of a plurality of electrically conductive vias (19) formed through the insulating layer (2).

## Claims

1. A package for devices which operate at microwave frequencies, comprising a base (1) of metal or metallised non-conductor to act as a support member of the package and also as a thermal and electrical ground for a device when mounted within the package, an electrically insulating layer (2) on the base (1), an electrically non-conductive lid (4) having a peripheral region which is sealingly coupled to the electrically insulating layer (2) whereby the lid (4) defines, at least in part, an internal cavity (6) of the package which in use receives said device, and at least one metallic track (5), which runs from an internal connection zone (14) within the internal cavity (6), where it can be connected to the said device, to an external connection zone (15) of the package where it can be connected to external circuitry, said track (5) being configured such as to maintain, at operating frequencies, a substantially constant impedance along its length when the lid (4) is in place.

2. A package as claimed in claim 1, in which there is a cut-out (3) in the electrically insulating layer (2) through to the base (1) to provide part of the internal cavity (6) for receiving and accommodating said device.

3. A package as claimed in claim 1, in which the electrically insulating layer (2) is continuous.

4. A package as claimed in claim 3, in which a metallised area is provided on the electrically insulating layer (2) for receiving said device, the metallised area being grounded to the base (1) by way of conductive vias formed through the insulating layer (2).

5. A package as claimed in any of claims 1 to 4, in which, each track (5) is of reduced width where it passes under said peripheral region of the lid (4) such as to maintain said substantially constant impedance when the lid is in place.

6. A package as claimed in any of claims 1 to 5, wherein the insulating layer (2) carries or includes integral lid markers (8) for self-aligning the lid (4) automatically into its correct position when it is applied to the insulating layer (2).

7. A package as claimed in claim 6 in which, in the case of a rectangular package, there is a respective one of the lid markers (8) at each of the four corners of the package.

8. A package for devices which operate at microwave frequencies, comprising a base (1) of metal or metallised non-conductor to act as a support member of the package and also as a thermal and electrical ground for a device when mounted within the package, an electrically insulating layer (2) on the base (1), an electrically non-conductive lid (4) having a peripheral region which is sealingly coupled to the electrically insulating layer (2) whereby the lid (4) defines, at least in part, an internal cavity (6) of the package which in use receives said device, and a plurality of metallic tracks (5) which run from an internal connection zone (14) within the internal cavity (6), where they can be connected to the device, to an external connection zone (15) of the package where they can be connected to external circuitry, each said track (5) being configured such as to maintain, at operating frequencies, a substantially constant impedance along its length when the lid (4) is in place.

9. A package for devices which operate at microwave frequencies, comprising a base (1) of metal or metallised non-conductor to act as a support member of the package and also as a thermal and electrical ground for a device when mounted within the package, an electrically insulating layer (2) on the base (1), an electrically non-conductive lid (4) having a peripheral region which is sealingly coupled to the electrically insulating layer (2) whereby the lid (4) defines, at least in part, an internal cavity (6) of the package which in use receives said device, and a plurality of metallic tracks (5) which run from an internal connection zone (14) within the internal cavity (6), where they can be connected to the device, to an external connection zone (15) of the package where they can be connected to external circuitry, one said track (5) being configured such as to maintain, at operating frequencies, a substantially constant impedance along its length when the lid (4) is in place.
